# NEUE EUROPÄISCHE PATENTSCHRIFT

(11) **EP 1 966 431 B2**
(45) Veröffentlichungstag und Bekanntmachung des Hinweises auf die Entscheidung über den Einspruch: **05.03.2014**
(45) Hinweis auf die Patenterteilung: 22.09.2010
(21) Anmeldenummer: 06830676.0
(22) Anmeldetag: 18.12.2006
(51) Int. Cl.: D06M 11/83, D06M 23/16, C09D 5/24, H05B 3/34

(54) **VERFAHREN ZUR HERSTELLUNG VON METALLISIERTEM TEXTILEM FLÄCHENGEBILDE, METALLISIERTES TEXTILES FLÄCHENGEBILDE UND VERWENDUNG DES SO HERGESTELLTEN METALLISIERTEN TEXTILEN FLÄCHENGEBILDES**
METHOD FOR PRODUCING PLANAR METALLISED TEXTILE STRUCTURES, PLANAR METALLISED TEXTILE STRUCTURE AND USE OF THE THUS PRODUCED PLANAR METALLISED TEXTILE STRUCTURE
PROCEDE POUR REALISER UNE STRUCTURE TEXTILE METALLISEE, STRUCTURE TEXTILE METALLISEE ET UTILISATION DE LA STRUCTURE TEXTILE METALLISEE AINSI REALISEE

(30) Priorität: 22.12.2005 DE 102005062028
(43) Veröffentlichungstag der Anmeldung: 10.09.2008
(73) Patentinhaber: BASF SE, 67056 Ludwigshafen (DE)
(72) Erfinder: RAFFAELE ADDAMO, Antonino, 67063 Ludwigshafen (DE); NÖRENBERG, Ralf, 67063 Ludwigshafen (DE); SOBOTKA, Bettina, 68167 Mannheim (DE); DURIS, Tibor, 67061 Ludwigshafen (DE); LOCHTMAN, Rene, 68161 Mannheim (DE); WAGNER, Norbert, 67112 Mutterstadt (DE); SCHNEIDER, Norbert, 67122 Altrip (DE); PFISTER, Jürgen, 67346 Speyer (DE)
(86) Internationale Anmeldenummer: PCT/EP2006/069799
(87) Internationale Veröffentlichungsnummer: WO 2007/074090

(56) Entgegenhaltungen:
- WO-A-98/29579
- WO-A-2005/020246
- WO-A1-98/29579
- WO-A1-2005/020246
- WO-A1-2009/109738
- WO-A2-01/50877
- DE-A1- 3 428 121
- DE-A1- 3 433 437
- DE-A1- 3 433 437
- DE-A1- 3 940 347
- DE-A1-102004 012 570
- DE-B- 1 036 834
- DE-C- 895 060
- DE-C- 977 064
- DE-T2- 60 125 016
- DE-T5-112009 000 486
- US-A- 3 933 712
- US-A- 3 933 712
- US-A- 4 670 351
- US-A1- 4 670 351
- US-B1- 6 194 692
- DATABASE WPI Week 198340 Derwent Publications Ltd., London, GB; AN 1983-779370 XP002424789 & JP 58 142842 A (AIKOH CO LTD) 25. August 1983 (1983-08-25)
- Informationsblatt von Exxon zu "Solvesso 100"

## Beschreibung

Die vorliegende Erfindung betrifft ein Verfahren zur Herstellung eines metallisierten textilen Flächengebildes, **dadurch gekennzeichnet, dass** man ein textiles Flächengebilde.
(A) mit einer wässrigen Druckformulierung bedruckt, enthaltend als Komponenten
   (a) mindestens ein Metallpulver, gewählt aus pulverförmigem Zn, Ni, Cu, Sn, Co, Mn, Fe, Mg, Pb, Cr und Bi, Mischungen und Legierungen der vorstehend genannten Metalle,
   (b) mindestens ein Bindemittel,
   (c) mindestens einen Emulgator und
   (d) gegebenenfalls mindestens einen Rheologiemodifizierer,
(B) in einem oder mehreren Schritten thermisch behandelt,
(C) ein weiteres Metall auf dem textilen Flächengebilde abscheidet.

Weiterhin betrifft die vorliegende Erfindung nach dem erfindungsgemäßen Verfahren hergestellte metallisierte textile Flächengebilde und Verwendung des so hergestellten metallisierten textilen Flächengebildes.

Die Herstellung von metallisierten textilen Flächengebilden ist ein Arbeitsgebiet mit großem Wachstumspotenzial. Metallisierte textile Flächengebilde lassen sich beispielsweise als Heizmäntel einsetzen, weiterhin als Modeartikel, beispielsweise für leuchtende Textilien, oder zur Herstellung von Textilien, die in der Medizin einschließlich der Prophylaxe eingesetzt werden können, beispielsweise zur Überwachung von Organen und ihrer Funktion. Weiterhin kann man metallisierte textile Flächengebilde zur Abschirmung von elektromagnetischer Strahlung einsetzen.

Bisherige Verfahren zur Herstellung sind jedoch noch sehr aufwändig und nicht flexibel. Man benötigt spezielle Geräte und kann herkömmliche Apparaturen wie beispielsweise konventionelle Webstühle nicht verwenden. So ist es beispielsweise bekannt, Metallfäden in Textil einzuarbeiten. Es ist jedoch in vielen Fällen nicht möglich, beispielsweise Kupferfäden und Polyesterfäden in einer befriedigenden Weise miteinander zu Geweben kombinieren, weil man spezielle Webstühle benötigt.

Wenn man versucht, den vorstehend geschilderten Nachteil dadurch zu umgehen, dass man Metallfäden in ein fertig konfektioniertes Textil einarbeitet. Eine derartige Vorgehensweise erfordert aber in der Regel viel Handarbeit und ist teuer.

Die Verwendung von elektrisch leitfähigen Polymerfasern birgt den zusätzlichen Nachteil, dass viele elektrisch leitfähige Polymere wie beispielsweise anoxidiertes Polypyrrol luft- und/oder feuchtigkeitsempfindlich sind.

Es bestand also die Aufgabe, ein Verfahren zur Herstellung von metallisierten textilen Flächengebilden bereit zu stellen, das die vorstehend beschriebenen Nachteile vermeidet. Weiterhin bestand die Aufgabe, metallisierte textile Flächengebilde bereit zu stellen. Weiterhin bestand die Aufgabe, Verwendungen für neue metallisierte textile Flächengebilde bereit zu stellen.

Demgemäß wurde das eingangs definierte Verfahren gefunden.

Das eingangs definierte Verfahren geht aus von einem textilen Flächengebilde, beispielsweise Gewirke, Strickwaren oder bevorzugt Gewebe oder Vliesstoffen (Non-Wovens). Textile Flächengebilde im Sinne der vorliegenden Erfindung können flexibel oder steif sein. Vorzugsweise handelt es sich um solche textile Flächengebilde, die man ein- oder mehrmals beispielsweise manuell biegen kann, ohne dass man visuell einen Unterschied zwischen vor dem Biegen und nach der Rückstellung aus dem gebogenen Zustand feststellen kann.

Textile Flächengebilde im Sinne der vorliegenden Erfindung können aus Naturfasern oder synthetischen Fasern oder Gemischen von Naturfasern und synthetischen Fasern sein. An Naturfasern seien beispielsweise Wolle, Flachs und bevorzugt Baumwolle zu nennen. An synthetischen Fasern seien beispielsweise Polyamid, Polyester, modifiziertes Polyester, Polyestermischgewebe, Polyamidmischgewebe, Polyacrylnitril, Triacetat, Acetat, Polycarbonat, Polypropylen, Polyvinylchlorid, Polyestermikrofasern genannt, bevorzugt sind Polyester und Mischungen von Baumwolle mit synthetischen Fasern, insbesondere Mischungen von Baumwolle und Polyester.

Zur Durchführung des erfindungsgemäßen Verfahrens bedruckt man ein textiles Flächengewebe in Schritt (A) mit einer wässrigen Druckformulierung, enthaltend
(a) mindestens ein Metallpulver (a), gewählt aus pulverförmigem Zn, Ni, Cu, Sn, Co, Mn, Fe, Mg, Pb, Cr und Bi, Mischungen und Legierungen der vorstehend genannten Metalle,
(b) mindestens ein Bindemittel,
(c) mindestens einen Emulgator und
(d) gegebenenfalls mindestens einen Rheologiemodifizierer.

Beispiele für Druckformulierungen sind Druckfarben, z. B. Tiefdruckfarben, Offsetdruckfarben, Drucktinten wie z. B. Tinten für das Valvolineverfahren und bevorzugt Druckpasten, vorzugsweise wässrige Druckpasten.

Metallpulver (a), gewählt aus pulverförmigem Zn, Ni, Cu, Sn, Co, Mn, Fe, Mg, Pb, Cr und Bi, Mischungen und Legierungen der vorstehend genannten Metalle, wird im Rahmen der vorliegenden Erfindung auch kurz als Metallpulver (a) bezeichnet.

Metallpulver (a) wird gewählt aus pulverförmigem Zn, Ni, Cu, Sn, Co, Mn, Fe, Mg, Pb, Cr und Bi, beispielsweise rein oder als Gemische oder in Form von Legierungen der genannten Metalle untereinander oder mit anderen Metallen. Geeignete Legierungen sind beispielsweise CuZn, CuSn, CuNi, SnPb, SnBi, SnCu, NiP, ZnFe, ZnNi, ZnCo und ZnMn. Bevorzugt einsetzbare Metallpulver (a) umfassen nur ein Metall, besonders bevorzugt sind Eisenpulver und Kupferpulver, ganz besonders bevorzugt Eisenpulver.

In einer Ausführungsform der vorliegenden Erfindung hat Metallpulver (a) einen mittleren Teilchendurchmesser von 0,01 bis 100 µm, bevorzugt von 0,1 bis 50 µm, besonders bevorzugt von 1 bis 10 µm (bestimmt durch Laserbeugungsmessung, beispielsweise an einem Gerät Microtrac X100).

In einer Ausführungsform ist Metallpulver (a) durch seine Partikeldurchmesserverteilung gekennzeichnet. Beispielsweise kann der Wert d₁₀ im Bereich von 0,01 bis 5 µm liegen, der Wert für d₅₀ im Bereich von 1 bis 10 µm und der Wert für d₉₀ im Bereich von 3 bis 100 µm, wobei gilt: d₁₀ < d₅₀ < d₉₀. Dabei hat vorzugsweise kein Partikel ein größeren Durchmesser als 100 µm.

Metallpulver (a) kann man in passivierter Form einsetzen, beispielsweise in einer zumindest partiell beschichteten ("gecoateten") Form. Als geeignete Beschichtungen seien beispielsweise anorganische Schichten wie Oxid des betreffenden Metalls, SiO₂ bzw. SiO₂·aq oder Phosphate beispielsweise des betreffenden Metalls genannt.

Die Partikel von Metallpulver (a) können grundsätzlich jede beliebige Form aufweisen, beispielsweise sind nadelförmige, plattenförmige oder kugelförmige Partikel einsetzbar, bevorzugt sind kugel- und plattenförmige.

In besonders bevorzugter Weise werden Metallpulver (a) mit kugelförmigen Partikeln, bevorzugt überwiegend mit kugelförmigen Partikeln, ganz besonders bevorzugt sogenannte Carbonyleisenpulver mit kugelförmigen Partikeln, verwendet.

Metallpulver (a) kann man in einer Ausführungsform von Schritt (A) so verdrucken, dass die Partikel von Metallpulver so dicht liegen, dass sie bereits zum Leiten von Strom in der Lage sind. In einer anderen Ausführungsform von Schritt (A) kann man so verdrucken, dass die Partikel von Metallpulver (a) so weit voneinander entfernt sind, dass sie nicht zum Leiten des Stroms in der Lage sind.

Die Herstellung von Metallpulvern (a) ist an sich bekannt. Man kann beispielsweise gängige Handelswaren oder nach an sich bekannten Verfahren hergestelltes Metallpulver (a) einsetzen, beispielsweise durch elektrolytische Abscheidung oder chemische Reduktion aus Lösungen von Salzen der betreffenden Metalle oder durch Reduktion eines oxidischen Pulvers beispielsweise mittels Wasserstoff, durch Versprühen oder Verdüsen einer Metallschmelze, insbesondere in Kühlmedien, beispielsweise Gasen oder Wasser.

Besonders bevorzugt verwendet man solches Metallpulver (a), das durch thermische Zersetzung von Eisenpentacarbonyl hergestellt wurde, im Rahmen der vorliegenden Erfindung auch Carbonyleisenpulver genannt.

Die Herstellung von Carbonyleisenpulver durch thermische Zersetzung von insbesondere Eisenpentacarbonyl Fe(CO)₅ wird beispielsweise in Ullmann's Encyclopedia of Industrial Chemistry, 5th Edition, Volume A14, Seite 599, beschrieben. Die Zersetzung des Eisenpentacarbonyls kann beispielsweise bei Normaldruck und beispielsweise bei erhöhten Temperaturen, z. B. im Bereich von 200 bis 300°C, z. B. in einem beheizbaren Zersetzer erfolgen, der ein Rohr aus einem hitzebeständigen Material wie Quarzglas oder V2A-Stahl in vorzugsweise vertikaler Position umfasst, das von einer Heizeinrichtung, beispielsweise bestehend aus Heizbändern, Heizdrähten oder aus einem von einem Heizmedium durchströmten Heizmantel, umgeben ist.

Der mittlere Teilchendurchmesser von Carbonyleisenpulver kann durch die Verfahrensparameter und Reaktionsführung bei der Zersetzung in weiten Bereichen gesteuert werden und liegt (Zahlenmittel) in der Regel bei 0,01 bis 100 µm, bevorzugt von 0,1 bis 50 µm, besonders bevorzugt von 1 bis 8 µm.

In einer Ausführungsform der vorliegenden Erfindung setzt man in Schritt (A) eine Druckformulierung ein, die enthält:
(a) mindestens ein Metallpulver, gewählt aus pulverförmigem Zn, Ni, Cu, Sn, Co, Mn, Fe, Mg, Pb, Cr und Bi, Mischungen und Legierungen der vorstehend genannten Metalle, bevorzugt ist Carbonyleisenpulver,
(b) mindestens ein Bindemittel,
(c) mindestens einen Emulgator, der anionisch, kationisch oder bevorzugt nichtionisch sein kann,
(d) gegebenenfalls mindestens einen Rheologiemodifizierer.

Erfindungsgemäß verwendete Druckformulierungen enthalten mindestens ein Bindemittel (b), bevorzugt mindestens eine wässrige Dispersion von mindestens einem filmbildenden Polymer, beispielsweise Polyacrylat, Polybutadien, Copolymere von mindestens einem Vinylaromaten mit mindestens einem konjugierten Dien und gegebenenfalls weiteren Comonomeren, beispielsweise Styrol-Butadien-Bindemittel. Weitere geeignete Bindemittel (b) sind gewählt aus Polyurethan, vorzugsweise anionischem Polyurethan, oder Ethylen-(Meth)acrylsäure-Copolymer. Bindemittel (b) können im Rahmen der vorliegenden Erfindung auch als Binder (b) bezeichnet werden.

Als Binder (b) geeignete Polyacrylate im Sinne der vorliegenden Erfindung sind beispielsweise erhältlich durch Copolymerisation von mindestens einem (Meth)acrylsäure-C₁-C₁₀-Alkylester, beispielsweise Acrylsäuremethylester, Acrylsäureethylester, Acrylsäure-n-Butylester, Methacrylsäure-n-butylester, Acrylsäure-2-ethylhexylester, mit mindestens einem weiteren Comonomer, beispielsweise einem weiteren (Meth)acrylsäure-C₁-C₁₀-Alkylester, (Meth)acrylsäure, (Meth)acrylamid, N-Methylol(meth)acrylamid, Glycidyl(meth)acrylat oder einer vinylaromatischen Verbindung wie beispielsweise Styrol.

Als Binder (b) geeignete vorzugsweise anionische Polyurethane im Sinne der vorliegenden Erfindung sind beispielsweise erhältlich durch Umsetzung von einem oder mehreren aromatischen oder vorzugsweise aliphatischen oder cycloaliphatischen Diisocyanat mit einem oder mehreren Polyesterdiolen und vorzugsweise einer oder mehreren Hydroxycarbonsäuren, z. B Hydroxyessigsäure, oder vorzugsweise Dihydroxycarbonsäuren, beispielsweise 1,1-Dimethylolpropionsäure, 1,1-Dimethylolbuttersäure oder 1,1-Dimethylolethansäure.

Als Bindemittel (b) besonders geeignete Ethylen-(Meth)acrylsäure-Copolymere sind beispielsweise durch Copolymerisation von Ethylen, (Meth)acrylsäure und gegebenenfalls mindestens einem weiteren Comonomer wie beispielsweise (Meth)acrylsäure-C₁-C₁₀-Alkylester, Maleinsäureanhydrid, Isobuten oder Vinylacetat erhältlich, vorzugsweise durch Copolymerisation bei Temperaturen im Bereich von 190 bis 350°C und Drücken im Bereich von 1500 bis 3500, bevorzugt 2000 bis 2500 bar.

Als Bindemittel (b) besonders geeignete Ethylen-(Meth)acrylsäure-Copolymere können beispielsweise bis zu 90 Gew.-% Ethylen einpolymerisiert enthalten und eine Schmelzeviskosität ν im Bereich von 60 mm²/s bis 10.000 mm²/s auf, bevorzugt 100 mm²/s bis 5.000 mm²/s aufweisen, gemessen bei 120°C.

Als Bindemittel (b) besonders geeignete Ethylen-(Meth)acrylsäure-Copolymere können beispielsweise bis zu 90 Gew.-% Ethylen einpolymerisiert enthalten und eine Schmelzemassefließrate (MFR) im Bereich von 1 bis 50 g/10 min, bevorzugt 5 bis 20 g/10 min, besonders bevorzugt 7 bis 15 g/10 min aufweisen, gemessen bei 160°C und einer Belastung von 325 g nach EN ISO 1133.

Als Bindemittel (b) besonders geeignete Copolymer von mindestens einem Vinylaromaten mit mindestens einem konjugierten Dien und gegebenenfalls weiteren Comonomeren, beispielsweise Styrol-Butadien-Bindemittel, enthalten mindestens eine ethylenisch ungesättigte Carbonsäure oder Dicarbonsäure oder ein geeignetes Derivat, beispielsweise das entsprechende Anhydrid, einpolymerisiert. Besonders geeignete Vinylaromaten sind para-Methylstyrol, α-Methylstyrol und insbesondere Styrol. Besonders geeignete konjugierte Diene sind Isopren, Chloropren und insbesondere 1,3-Butadien. Als besonders geeignete ethylenisch ungesättigte Carbonsäuren oder Dicarbonsäuren oder geeignete Derivate davon seien (Meth)acrylsäure, Maleinsäure, Itaconsäure, Maleinsäureanhydrid bzw. Itaconsäureanhydrid beispielhaft genannt.

In einer Ausführungsform der vorliegenden Erfindung enthalten als Bindemittel (b) besonders geeignete Copolymere von mindestens einem Vinylaromaten mit mindestens einem konjugierten Dien und gegebenenfalls weiteren Comonomeren einpolymerisiert:
19,9 bis 80 Gew.-% Vinylaromat,
19,9 bis 80 Gew.-% konjugiertes Dien,
0,1 bis 10 Gew.-% ethylenisch ungesättigte Carbonsäure oder Dicarbonsäure oder ein geeignetes Derivat, beispielsweise das entsprechende Anhydrid.

In einer Ausführungsform der vorliegenden Erfindung hat Bindemittel (b) bei 23°C eine dynamische Viskosität im Bereich von 10 bis 100 dPa·s, bevorzugt 20 bis 30 dPa·s, bestimmt beispielsweise durch Rotationsviskosimetrie, beispielsweise mit einem Haake-Viskosimeter.

Als Emulgator (c) kann man anionische, kationische oder vorzugsweise nicht-ionische oberflächenaktive Substanzen verwenden.

Beispiele für geeignete kationische Emulgatoren (c) sind beispielsweise einen C₆-C₁₈-Alkyl-, -Aralkyl- oder heterocyclischen Rest aufweisende primäre, sekundäre, tertiäre oder quartäre Ammoniumsalze, Alkanolammoniumsalze, Pyridiniumsalze, Imidazoliniumsalze, Oxazoliniumsalze, Morpholiniumsalze, Thiazoliniumsalze sowie Salze von Aminoxiden, Chinoliniumsalze, Isochinoliniumsalze, Tropyliumsalze, Sulfoniumsalze und Phosphoniumsalze. Beispielhaft genannt seien Dodecylammoniumacetat oder das entsprechende Hydrochlorid, die Chloride oder Acetate der verschiedenen 2-(N,N,N-Trimethylammonium)ethylparaffinsäureester, N-Cetylpyridiniumchlorid, N-Laurylpyridiniumsulfat sowie N-Cetyl-N,N,N-trimethylammoniumbromid, N-Dodecyl-N,N,N-trimethylammoniumbromid, N,N-Distearyl-N,N-dimethylammoniumchlorid sowie das Gemini-Tensid N,N'-(Lauryldimethyl)ethylendiamindibromid.

Beispiele für geeignete anionische Emulgatoren (c) sind Alkalimetall- und Ammoniumsalze von Alkylsulfaten (Alkylrest: C₈ bis C₁₂), von Schwefelsäurehalbestern ethoxylierter Alkanole (Ethoxylierungsgrad: 4 bis 30, Alkylrest: C₁₂-C₁₈) und ethoxylierter Alkylphenole (Ethoxylierungsgrad: 3 bis 50, Alkylrest: C₄-C₁₂), von Alkylsulfonsäuren (Alkylrest: C₁₂-C₁₈), von Alkylarylsulfonsäuren (Alkylrest: C₉-C₁₈) und von Sulfosuccinaten wie beispielsweise Sulfobernsteinsäuremono- oder diestern. Bevorzugt sind aryl- oder alkylsubstituierte Polyglykolether, weiterhin Substanzen, die in US 4,218,218 beschrieben sind, und Homologe mit y (aus den Formeln aus US 4,218,218) im Bereich von 10 bis 37.

Besonders bevorzugt sind nichtionische Emulgatoren (c) wie beispielsweise ein- oder vorzugsweise mehrfach alkoxylierte C₁₀-C₃₀-Alkanole, bevorzugt mit drei bis hundert Mol C₂-C₄-Alkylenoxid, insbesondere Ethylenoxid alkoxylierte Oxo- oder Fettalkohole.

Beispiele für besonders geeignete mehrfach alkoxylierte Fettalkohole und Oxoalkohole sind

n-C₁₈H₃₇O-(CH₂CH₂O)₈₀-H,

n-C₁₈H₃₇O-(CH₂CH₂O)₇₀-H,

n-C₁₈H₃₇O-(CH₂CH₂O)₆₀-H,

n-C₁₈H₃₇O-(CH₂CH₂O)₅₀-H,

n-C₁₈H₃₇O-(CH₂CH₂O)₂₅-H,

n-C₁₈H₃₇O-(CH₂CH₂O)₁₂-H,

n-C₁₆H₃₃O-(CH₂CH₂O)₈₀-H,

n-C₁₆H₃₃O-(CH₂CH₂O)₇₀-H,

n-C₁₆H₃₃O-(CH₂CH₂O)₆₀-H,

n-C₁₆H₃₃O-(CH₂CH₂O)₅₀-H,

n-C₁₆H₃₃O-(CH₂CH₂O)₂₅-H,

n-C₁₆H₃₃O-(CH₂CH₂O)₁₂-H,

n-C₁₂H₂₅O-(CH₂CH₂O)₁₁-H,

n-C₁₂H₂₅O-(CH₂CH₂O)₁₈-H,

n-C₁₂H₂₅O-(CH₂CH₂O)₂₅-H,

n-C₁₂H₂₅O-(CH₂CH₂O)₅₀-H,

n-C₁₂H₂₅O-(CH₂CH₂O)₈₀-H,

n-C₃₀H₆₁O-(CH₂CH₂O)₈-H,

n-C₁₀H₂₁O-(CH₂CH₂O)₉-H,

n-C₁₀H₂₁O-(CH₂CH₂O)₇-H,

n-C₁₀H₂₁O-(CH₂CH₂O)₅-H,

n-C₁₀H₂₁O-(CH₂CH₂O)₃-H,

und Mischungen der vorstehend genannten Emulgatoren, beispielsweise Mischungen von n-C₁₈H₃₇O-(CH₂CH₂O)₅₀-H und n-C₁₆H₃₃O-(CH₂CH₂O)₅₀-H,
wobei die Indices jeweils als Mittelwerte (Zahlenmittel) aufzufassen sind.

In einer Ausführungsform der vorliegenden Erfindung können in Schritt (A) eingesetzte Druckformulierungen mindestens einen Rheologiemodifizierer (d) enthalten, ausgewählt aus Verdickungsmitteln (d1), die auch als Verdicker bezeichnet werden können, und die Viskosität senkenden Mitteln (d2).

Geeignete Verdickungsmittel (d1) sind beispielsweise natürliche Verdickungsmittel oder vorzugsweise synthetische Verdickungsmittel. Natürliche Verdickungsmittel sind solche Verdickungsmittel, die Naturprodukte sind oder durch Aufarbeitung wie beispielsweise Reinigungsoperationen, insbesondere Extraktion von Naturprodukten erhalten werden können. Beispiele für anorganische natürliche Verdickungsmittel sind Schichtsilikate wie beispielsweise Bentonit. Beispiele für organische natürliche Verdickungsmittel sind vorzugsweise Proteine wie beispielsweise Casein oder bevorzugt Polysaccharide. Besonders bevorzugte natürliche Verdickungsmittel sind gewählt aus Agar-Agar, Carrageen, Gummi arabicum, Alginaten wie beispielsweise Natriumalginat, Kaliumalginat, Ammoniumalginat, Calciumalginat und Propylengycolalginat, Pektinen, Polyosen, Johannisbrotbaum-Kernmehl (Carubin) und Dextrinen.

Bevorzugt ist der Einsatz von synthetischen Verdickungsmitteln, die gewählt sind aus im Allgemeinen flüssigen Lösungen von synthetischen Polymeren, insbesondere Acrylaten, in beispielsweise Weißöl oder als wässrige Lösungen, und aus synthetischen Polymeren in getrockneter Form, beispielsweise als durch Sprühtrocknung hergestelltem Pulver. Als Verdickungsmittel (d1) eingesetzte synthetische Polymere enthalten Säuregruppen, die vollständig oder zu einem gewissen Prozentsatz mit Ammoniak neutralisiert werden. Beim Fixierprozess wird Ammoniak freigesetzt, wodurch der pH-Wert gesenkt wird und die eigentliche Fixierung beginnt. Das für die Fixierung notwendige Absenken des pH-Wertes kann alternativ durch Zusatz von nichtflüchtigen Säuren wie z.B. Zitronensäure, Bernsteinsäure, Glutarsäure oder Äpfelsäure erfolgen.

Ganz besonders bevorzugte synthetische Verdickungsmittel sind gewählt aus Copolymeren von 85 bis 95 Gew.-% Acrylsäure, 4 bis 14 Gew.-% Acrylamid und 0,01 bis maximal 1 Gew.-% des (Meth)acrylamidderivats der Formel I 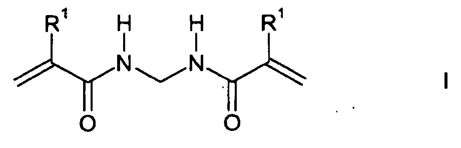 mit Molekulargewichten M_{w} im Bereich von 100.000 bis 2.000.000 g/mol, in denen die Reste R¹ gleich oder verschieden sein können und Methyl oder Wasserstoff bedeuten können.

Weitere geeignete Verdickungsmittel (d1) sind gewählt aus Reaktionsprodukten von aliphatischen Diisocyanaten wie beispielsweise Trimethylendiisocyanat, Tetramethylendiisocyanat, Hexamethylendiisocyanat oder Dodecan-1,12-diisocyanat mit vorzugsweise 2 Äquivalenten mehrfach alkoxyliertem Fettalkohol oder Oxoalkohol, beispielsweise 10 bis 150-fach ethoxyliertem C₁₀-C₃₀-Fettalkohol oder C₁₁-C₃₁-Oxoalkohol.

Geeignete die Viskosität senkende Mittel (d2) sind beispielsweise organische Lösungsmittel wie Dimethylsulfoxid (DMSO), N-Methylpyrrolidon (NMP), N-Ethylpyrrolidon (NEP), Ethylenglykol, Diethylenglykol, Butylykol, Dibutylglykol, und beispielsweise Restalkohol-freiem alkoxyliertem n-C₄-C₈-Alkanol, bevorzugt Restalkohol-freiem einbis 10-fach, besonders bevorzugt 3- bis 6-fach ethoxyliertem n-C₄-C₈-Alkanol. Dabei ist unter Restalkohol das jeweils nicht alkoxylierte n-C₄-C₈-Alkanol zu verstehen.

In einer Ausführungsform der vorliegenden Erfindung enthält in Schritt (A) eingesetzte Druckformulierung
im Bereich von 10 bis 90 Gew.-%, bevorzugt 50 bis 85 Gew.-%, besonders bevorzugt 60 bis 80 Gew.-% Metallpulver (a),
im Bereich von 1 bis 20 Gew.-%, bevorzugt 2 bis 15 Gew.-% Bindemittel (b),
im Bereich von 0,1 bis 4 Gew.-%, bevorzugt bis 2 Gew.-% Emulgator (c),
im Bereich von 0 bis 5 Gew.-%, bevorzugt 0,2 bis 1 Gew.-% Rheologiemodifizierer (d),
wobei Angaben in Gew.-% jeweils auf die gesamte in Schritt (A) eingesetzte Druckformulierung bezogen sind und sich bei Bindemittel (b) auf den Feststoffgehalt des jeweiligen Bindemittels (b) beziehen.

In einer Ausführungsform der vorliegenden Erfindung kann man in Schritt (A) des erfindungsgemäßen Verfahrens mit einer Druckformulierung bedrucken, die zusätzlich zu Metallpulver (a) und gegebenenfalls Bindemittel (b), Emulgator (c) und gegebenenfalls Rheologiemodifizierer (d) mindestens ein Hilfsmittel (e) enthält. Als Hilfsmittel (e) seien Griffverbesserer, Entschäumer, Netzmittel, Egalisiermittel, Harnstoff, Wirkstoffe wie beispielsweise Biozide oder Flammfestmittel, beispielhaft genannt:

Geeignete Entschäumer sind beispielsweise silikonhaltige Entschäumer wie beispielsweise solche der Formel HO-(CH₂)₃-Si(CH₃)[OSi(CH₃)₃]₂ und HO-(CH₂)₃-Si(CH₃)[OSi(CH₃)₃][OSi(CH₃)₂OSi(CH₃)₃], nicht alkoxyliert oder mit bis zu 20 Äquivalenten Alkylenoxid und insbesondere Ethylenoxid alkoxyliert. Auch Silikon-freie Entschäumer sind geeignet wie beispielsweise mehrfach alkoxylierte Alkohole, z.B. Fettalkoholalkoxylate, bevorzugt 2 bis 50-fach ethoxylierte vorzugsweise unverzweigte C₁₀-C₂₀-Alkanole, unverzweigte C₁₀-C₂₀-Alkanole und 2-Ethylhexan-1-ol. Weitere geeignete Entschäumer sind Fettsäure-C₈-C₂₀-alkylester, bevorzugt Stearinsäure-C₁₀-C₂₀-alkylester, bei denen C₈-C₂₀-Alkyl, bevorzugt C₁₀-C₂₀-Alkyl unverzweigt oder verzweigt sein kann.

Geeignete Netzmittel sind beispielsweise nichtionische, anionische oder kationische Tenside, insbesondere Ethoxylierungs- und/oder Propoxylierungsprodukte von Fettalkoholen oder Propylenoxid-Ethylenoxid-Blockcopolymere, ethoxylierte oder propoxylierte Fett- oder Oxoalkohole, weiterhin Ethoxylate von Ölsäure oder Alkylphenolen, Alkylphenolethersulfate, Alkylpolyglycoside, Alkylphosphonate, Alkylphenylphosphonate, Alkylphosphate, oder Alkylphenylphosphate.

Geeignete Egalisiermittel sind beispielsweise Blockcopolymerisate von Ethylenoxid und Propylenoxid mit Molekulargewichten Mₙ im Bereich von 500 bis 5000 g/mol, bevorzugt 800 bis 2000 g/mol. Ganz besonders besonders bevorzugt sind Blockcopolymerisate aus Propylenoxid/Ethylenoxid beispielsweise der Formel EO₈PO₇EO₈, wobei EO für Ethylenoxid und PO für Propylenoxid steht.

Geeignete Biozide sind beispielsweise als Proxel-Marken im Handel befindlich. Beispielhaft seien genannt: 1,2-Benzisothiazolin-3-on ("BIT") (kommerziell erhältlich als Proxel®-Marken der Fa. Avecia Lim.) und dessen Alkalimetallsalze; andere geeignete Biozide sind 2-Methyl-2H-isothiazol-3-on ("MIT") und 5-Chlor-2-methyl-2H-isothiazol-3-on ("CIT").

In einer Ausführungsform der vorliegenden Erfindung enthält in Schritt (A) eingesetzte Druckformulierung bis zu 30 Gew.-% Hilfsmittel (e), bezogen auf die Summe aus Metallpulver (a), Bindemittel (b), Emulgator (c) und gegebenenfalls Rheologiemodifizierer (d).

In einer Ausführungsform der vorliegenden Erfindung bedruckt man in Schritt (A) vollflächig mit Druckformulierung, die mindestens ein Metallpulver (a), Bindemittel (b) und Emulgator (c) enthält. In einer anderen Ausführungsform druckt man ein Muster von Metallpulver (a) auf, indem man Textil an einigen Stellen mit Druckformulierung bedruckt, die Metallpulver (a), Bindemittel (b) und Emulgator (c) enthält, und an anderen Stellen nicht. Vorzugsweise verdruckt man solche Muster, bei denen Metallpulver (a) in Form von geraden oder vorzugsweise gebogenen Streifenmustern oder Linienmustern auf Textil angeordnet sind, wobei die genannten Linien beispielsweise eine Breite und Dicke jeweils im Bereich von 0,1 µm bis 5 mm und die genannten Streifen eine Breite im Bereich von 5,1 mm bis beispielsweise 10 cm oder gegebenenfalls mehr und eine Dicke von 0,1 µm bis 5 mm haben können.

In einer speziellen Ausführungsform der vorliegenden Erfindung verdruckt man solche Streifenmuster oder Linienmuster von Metallpulver (a), bei denen sich die Streifen bzw. Linien weder berühren noch schneiden.

In einer anderen speziellen Ausführungsform der vorliegenden Erfindung verdruckt man solche Streifenmuster oder Linienmuster von Metallpulver (a), bei denen sich die Streifen bzw. Linien kreuzen, beispielsweise dann, wenn man aufgedruckte Schaltkreise herstellen will.

In einer Ausführungsform der vorliegenden Erfindung bedruckt man in Schritt (A) nach verschiedenen Verfahren, die an sich bekannt sind. In einer Ausführungsform der vorliegenden Erfindung verwendet man eine Schablone, durch die man die Druckformulierung, die Metallpulver (a), Bindemittel (b) und Emulgator (c) enthält, mit einer Rakel presst. Das vorstehend beschriebene Verfahren gehört zu den Siebdruckverfahren. Weitere geeignete Druckverfahren sind

Tiefdruckverfahren und Flexodruckverfahren. Ein weiteres geeignetes Druckverfahren ist gewählt aus Valve-Jet-Verfahren. Bei Valve-Jet-Verfahren verwendet man solche Druckformulierung, die vorzugsweise keine Verdickungsmittel (d1) enthält.

Zur Durchführung des erfindungsgemäßen Verfahrens behandelt man in Schritt (B) ein bedrucktes textiles Flächengebilde thermisch, und zwar in einem oder mehreren Schritten. Wünscht man mehrere Schritte zur thermischen Behandlung durchzuführen, so kann man mehrere Schritte bei der gleichen oder vorzugsweise bei verschiedenen Temperaturen durchführen.

In Schritt (B) bzw. jedem einzelnen Schritt (B), im Folgenden auch als.Schritt (B1), (B2), (B3) usw. bezeichnet, kann man beispielsweise bei Temperaturen im Bereich von 50 bis 200°C behandeln.

In Schritt (B) bzw. jedem einzelnen Schritt (B) kann man beispielsweise über einen Zeitraum von 10 Sekunden bis 15 Minuten, bevorzugt 30 Sekunden bis 10 Minuten behandeln.

Besonders bevorzugt behandelt man in einem ersten Schritt (B1) bei Temperaturen im Bereich von beispielsweise 50 bis 110°C über einen Zeitraum von 30 Sekunden bis 3 Minuten und in einem zweiten Schritt (B2) anschließend bei Temperaturen im Bereich von 130°C bis 200°C über einen Zeitraum von 30 Sekunden bis 15 Minuten.

Man kann Schritt (B) bzw. jeden einzelnen Schritt (B) in an sich bekannten Geräten durchführen, zum Beispiel in Trockenschränken, Spannrahmen oder Vakuumtrockenschränken.

Zur Durchführung des erfindungsgemäßen Verfahrens scheidet man in Schritt (C) ein weiteres Metall auf dem textilen Flächengebilde ab. Unter "dem textilen Flächengebilde" ist dabei das zuvor in Schritt (A) bedruckte und in Schritt (B) thermisch behandelte textile Flächengebilde zu verstehen.

Man kann in Schritt (C) auch mehrere weitere Metalle abscheiden, bevorzugt ist es jedoch, nur ein weiteres Metall abzuscheiden.

In einer Ausführungsform der vorliegenden Erfindung wählt man als Metallpulver (a) Carbonyleisenpulver und als weiteres Metall Silber, Gold und insbesondere insbesondere Kupfer.

In einer Ausführungsform der vorliegenden Erfindung, im Folgenden auch als Schritt (C1) bezeichnet, geht man so vor, dass man in Schritt (C1) ohne externe Spannungsquelle arbeitet und dass das weitere Metall in Schritt (C1) in der elektrochemischen Spannungsreihe der Elemente, in alkalischer oder vorzugsweise in saurer Lösung, ein stärker positives Normalpotenzial aufweist als Metall, das Metallpulver (a) zugrunde liegt, und als Wasserstoff.

Dazu kann man beispielsweise so vorgehen, dass man in Schritt (A) bedrucktes und in Schritt (B) thermisch behandeltes textiles Flächengebilde mit einer basischen, neutralen oder vorzugsweise sauren vorzugsweise wässrigen Lösung von Salz von weiterem Metall und gegebenenfalls einem oder mehreren Reduktionsmitteln behandelt, beispielsweise indem man es in die betreffende Lösung einlegt.

In einer Ausführungsform der vorliegenden Erfindung behandelt man in Schritt (C1) im Bereich von 0,5 Minuten bis zu 12 Stunden, bevorzugt bis zu 30 Minuten.

In einer Ausführungsform der vorliegenden Erfindung behandelt man in Schritt (C1) mit einer basischen, neutralen oder vorzugsweise sauren Lösung von Salz von weiterem Metall, die eine Temperatur im Bereich von 0 bis 100°C, bevorzugt 10 bis 80°C aufweist.

Zusätzlich kann man in Schritt (C1) ein oder mehrere Reduktionsmittel zusetzen. Wählt man beispielsweise Kupfer als weiteres Metall, so kann man als Reduktionsmittel beispielsweise Aldehyde, insbesondere reduzierende Zucker oder Formaldehyd als Reduktionsmittel zusetzen. Wählt man beispielsweise Nickel als weiteres Metall, so kann man beispielsweise Alkalihypophosphit, insbesondere NaH₂PO₂·2H₂O, oder Borariate, insbesondere NaBH₄, als Reduktionsmittel zusetzen.

In einer anderen Ausführungsform, im Folgenden auch als Schritt (C2) bezeichnet, der vorliegenden Erfindung geht man so vor, dass man in Schritt (C2) mit externer Spannungsquelle arbeitet und dass das weitere Metall in Schritt (C2) in der elektrochemischen Spannungsreihe der Elemente in saurer oder alkalischer Lösung ein stärker oder schwächer positives Normalpotenzial aufweisen kann als Metall, das Metallpulver (a) zugrunde liegt. Vorzugsweise kann man dazu als Metallpulver (a) Carbonyleisenpulver und als weiteres Metall Nickel, Zink oder insbesondere Kupfer wählen. Dabei beobachtet man für den Fall, dass das weitere Metall in Schritt (C2) in der elektrochemischen Spannungsreihe der Elemente ein stärker positives Normalpotenzial aufweist als Wasserstoff und als Metall, das Metallpulver (a) zugrunde liegt, dass zusätzlich weiteres Metall in Analogie zu Schritt (C1) abgeschieden wird.

Zur Durchführung von Schritt (C2) kann man beispielsweise einen Strom mit einer Stärke im Bereich von 10 bis 100 A, bevorzugt 12 bis 50 A anlegen.

Zur Durchführung von Schritt (C2) kann man beispielsweise über einen Zeitraum von 1 bis 60 Minuten unter Verwendung einer externen Spannungsquelle arbeiten.

In einer Ausführungsform der vorliegenden Erfindung kombiniert man Schritt (C1) und Schritt (C2) in der Weise, dass man zunächst ohne und danach mit externer Spannungsquelle arbeitet und dass das weitere Metall in Schritt (C) in der elektrochemischen Spannungsreihe der Elemente ein stärker positives Normalpotenzial aufweist kann als Metall, das Metallpulver (a) zugrunde liegt.

In einer Ausführungsform der vorliegenden Erfindung setzt man der Lösung von weiterem Metall einen oder mehrere Hilfsstoffe zu. Als Hilfsstoffe seien beispielhaft genannt: Puffer, Tenside, Polymere, insbesondere partikelförmige Polymere, deren Partikeldurchmesser im Bereich von 10 nm bis 10 µm liegt, Entschäumer, ein oder mehrere organische Lösungsmittel, ein oder mehrere Komplexbildner.

Besonders geeignete Puffer sind Essigsäure/Acetat-Puffer.

Besonders geeignete Tenside sind gewählt aus kationischen, anionischen und insbesondere nicht-ionischen Tensiden.

Als kationische Tenside seien beispielhaft genannt: Beispiele für geeignete kationische Emulgatoren (c) sind beispielsweise einen C₆-C₁₈-Alkyl-, -Aralkyl- oder heterocyclischen Rest aufweisende primäre, sekundäre, tertiäre oder quartäre Ammoniumsalze, Alkanolammoniumsalze, Pyridiniumsalze, Imidazoliniumsalze, Oxazoliniumsalze, Morpholiniumsalze, Thiazoliniumsalze sowie Salze von Aminoxiden, Chinoliniumsalze, Isochinoliniumsalze, Tropyliumsalze, Sulfoniumsalze und Phosphoniumsalze. Beispielhaft genannt seien Dodecylammoniumacetat oder das entsprechende Hydrochlorid, die Chloride oder Acetate der verschiedenen 2-(N,N,N-Trimethylammonium)ethylparaffinsäureester, N-Cetylpyridiniumchlorid, N-Laurylpyridiniumsulfat sowie N-Cetyl-N,N,N-trimethylammoniumbromid, N-Dodecyl-N,N,N-trimethylammoniumbromid, N,N-Distearyl-N,N-dimethylammoniumchlorid sowie das Gemini-Tensid N,N'-(Lauryldimethyl)ethylendiamindibromid.

Beispiele für geeignete anionische Tenside sind Alkalimetall- und Ammoniumsalze von Alkylsulfaten (Alkylrest: C₈ bis C₁₂), von Schwefelsäurehalbestern ethoxylierter Alkanole (Ethoxylierungsgrad: 4 bis 30, Alkylrest: C₁₂-C₁₈) und ethoxylierter Alkylphenole (Ethoxylierungsgrad: 3 bis 50, Alkylrest: C₄-C₁₂), von Alkylsulfonsäuren (Alkylrest: C₁₂-C₁₈), von Alkylarylsulfonsäuren (Alkylrest: C₉-C₁₈) und von Sulfosuccinaten wie beispielsweise Sulfobernsteinsäuremono- oder diestern. Bevorzugt sind aryl- oder alkylsubstituierte Polyglykolether, weiterhin Substanzen, die in US 4,218,218 beschrieben sind, und Homologe mit y (aus den Formeln aus US 4,218,218) im Bereich von 10 bis 37.

Besonders bevorzugt sind nichtionische Tenside wie beispielsweise ein- oder vorzugsweise mehrfach alkoxylierte C₁₀-C₃₀-Alkanole, bevorzugt mit drei bis hundert Mol C₂-C₄-Alkylenoxid, insbesondere Ethylenoxid alkoxylierte Oxo- oder Fettalkohole.

Geeignete Entschäumer sind beispielsweise silikonhaltige Entschäumer wie beispielsweise solche der Formel HO-(CH₂)₃-Si(CH₃)[OSi(CH₃)₃]₂ und HO-(CH₂)₃-Si(CH₃)[OSi(CH₃)₃][OSi(CH₃)₂OSi(CH₃)₃], nicht alkoxyliert oder mit bis zu 20 Äquivalenten Alkylenoxid und insbesondere Ethylenoxid alkoxyliert. Auch Silikon-freie Entschäumer sind geeignet wie beispielsweise mehrfach alkoxylierte Alkohole, z.B. Fettalkoholalkoxylate, bevorzugt 2 bis 50-fach ethoxylierte vorzugsweise unverzweigte C₁₀-C₂₀-Alkanole, unverzweigte C₁₀-C₂₀-Alkanole und 2-Ethylhexan-1-ol. Weitere geeignete Entschäumer sind Fettsäure-C₈-C₂₀-alkylester, bevorzugt Stearinsäure-C₁₀-C₂₀-alkylester, bei denen C₈-C₂₀-Alkyl, bevorzugt C₁₀-C₂₀-Alkyl unverzweigt oder verzweigt sein kann.

Geeignete Komplexbildner sind solche Verbindungen, die Chelate bilden. Bevorzugt sind solche Komplexbildner, die gewählt sind aus Aminen, Diamen, und Triaminen, die mindestens eine Carbonsäuregruppe tragen. Beispielhaft seien Nitrilotriessigsäure, Ethylendiamintetraessigsäure und Diethylenpentaaminpentaessigsäure sowie die korrespondierenden Alkalimetallsalze genannt.

In einer Ausführungsform der vorliegenden Erfindung scheidet man so viel weiteres Metall ab, dass man eine Schichtdicke im Bereich von 100 nm bis 100 µm, bevorzugt von 1 µm bis 10 µm erzeugt.

Bei der Durchführung von Schritt (C) wird Metallpulver (a) in den meisten Fällen partiell oder vollständig durch weiteres Metall ersetzt, wobei die Morphologie von weiterem abgeschiedenen Metall nicht identisch mit der Morphologie von Metallpulver (a) zu sein braucht.

Nach der Beendigung des Abscheidens von weiterem Metall erhält man erfindungsgemäß metallisiertes textiles Flächengebilde. Man kann erfindungsgemäß metallisiertes textiles Flächengebilde noch ein- oder mehrmals spülen, beispielsweise mit Wasser.

Zur Herstellung von beispielsweise solchen textilen Flächengebilden, die zur Herstellung von elektrisch beheizbaren Autositzen verwendet werden sollen, kann man noch an den Enden auf an sich bekannte Weise Stromkabel befestigen, beispielsweise anlöten.

Ein weiterer Gegenstand der vorliegenden Erfindung sind metallisierte textile Flächengebilde, erhältlich nach dem vorstehend beschriebenen Verfahren. Erfindungsgemäße metallisierte textile Flächengebilde lassen sich nicht nur gut und gezielt herstellen, so kann man beispielsweise durch die Art des aufgedruckten Musters von Metallpulver (a) und durch die Menge an abgeschiedenem weiteren Metall beispielsweise die Flexibilität und die elektrische Leitfähigkeit gezielt beeinflussen. Erfindungsgemäße metallisierte textile Flächengebilde sind auch flexibel einsetzbar, beispielsweise in Anwendungen für elektrisch leitfähige Textilien.

In einer Ausführungsform der vorliegenden Erfindung weisen erfindungsgemäße mit einem Linien- oder Streifenmuster bedruckte metallisierte textile Flächengebilde einen spezifischen Widerstand im Bereich von 1 mΩ/cm² bis 1 MΩ2/cm² bzw. im Bereich von 1 µΩ/cm bis 1 MΩ/cm auf, gemessen bei Zimmertemperatur und entlang der betreffenden Streifen bzw. Linien.

In einer Ausführungsform der vorliegenden Erfindung umfassen erfindungsgemäße mit einem Linien- oder Streifenmuster bedruckte metallisierte textile Flächengebilde mindestens zwei Kabel, die an den jeweiligen Enden von Linien oder Streifen auf an sich bekannte Weise befestigt sind, beispielsweise angelötet.

Ein weiterer Gegenstand der vorliegenden Erfindung ist die Verwendung von erfindungsgemäßen metallisierten textilen Flächengebilden beispielsweise zur Herstellung von beheizbaren Textilen, insbesondere beheizbaren Autositzen und beheizbaren Teppichen, Tapeten und Bekleidung.

Ein weiterer Gegenstand der vorliegenden Erfindung ist die Verwendung von erfindungsgemäßen metallisierten textilen Flächengebilden als oder zur Herstellung von solchen Textilien, die Strom in Wärme umwandeln, weiterhin von solchen Textilien, die natürliche oder künstliche elektrische Felder abschirmen können, von Textil-integrierter Elektronik und von RFID-Textilien. Unter RFID-Textilien sind beispielsweise Textilien zu verstehen, die eine Radiofrequenz identifizieren können, z.B. mit Hilfe eines Geräts, das als Transponder oder englisch RFID tag bezeichnet wird. Derartige Geräte benötigen keine interne Stromquelle.

Beispiele für Textil-integrierte Elektronik sind mit Textil integrierte Sensoren, Transistoren, Chips, LED's (Licht-emittierende Dioden, englisch: light emitting diodes), Solarmodule, Solarzellen und Peltier-Elemente. So sind mit Textil integrierte Sensoren beispielsweise geeignet, um die Körperfunktionen von Säuglingen oder älteren Menschen zu überwachen. Geeignete Anwendungen sind weiterhin Warnbekleidung wie z. B. Warnwesten.

Gegenstand der vorliegenden Erfindung sind deshalb Verfahren zur Herstellung von beheizbaren Textilien, beispielsweise beheizbaren Tapeten, Teppichen und Vorhängen, beheizbaren Autositzen und beheizbaren Teppichen, weiterhin zur Herstellung von solchen Textilien, die Strom in Wärme umwandeln, weiterhin von solchen Textilien, die elektrische Felder abschirmen können, Textil-integrierte Elektronik und von RFID-Textilien unter Verwendung von erfindungsgemäßen metallisierten textilen Flächengebilden. Erfindungsgemäße Verfahren zur Herstellung von beheizbaren Textilien, von solchen Textilien, die Strom in Wärme umwandeln, weiterhin für solche Textilien, die elektrische Felder abschirmen können, und von RFID-Textilien unter Verwendung von erfindungsgemäßen metallisierten textilen Flächengebilden kann man beispielsweise so durchführen, dass man erfindungsgemäßes metallisiertes textiles Flächengebilde konfektioniert.

Ein spezieller Gegenstand der vorliegenden Erfindung sind beheizbare Autositze, hergestellt unter Verwendung von erfindungsgemäßem metallisiertem textilem Flächengebilde. Erfindungsgemäße beheizbare Autositze benötigen beispielsweise wenig Strom, um eine angenehme Sitztemperatur zu erzeugen, und schonen daher die Autobatterie, was insbesondere im Winter vorteilhaft ist. Weiterhin lassen sich nach dem erfindungsgemäßen Verfahren beheizbare Autositze mit flexiblem Design herstellen, was für eine komfortable Wärmeverteilung sorgt, beispielsweise durch nur wenige "hot spots".

Ein spezieller Gegenstand der vorliegenden Erfindung sind Tapeten, Teppiche und Vorhänge, hergestellt unter Verwendung von oder bestehend aus erfindungsgemäßem metallisiertem textilem Flächengebilde.

Die Erfindung wird durch Arbeitsbeispiele erläutert.

### I. Herstellung einer erfindungsgemäßen Druckpaste

Man verrührte miteinander:
54 g Wasser
750 g Carbonyleisenpulver, nicht passiviert, d₁₀ 3 µm, d₅₀ 4,5 µm, d₉₀ 9 µm.
125 g einer wässrigen Dispersion, pH-Wert 6,6, Feststoffgehalt 39,3 Gew.-%, eines statistischen Emulsionscopolymerisats von
1,9 Gew.-Teilen N-Methylolacrylamid, 1,3 Gew.-Teilen Acrylsäure, 9,8 Gew.-Teilen Styrol, 40 Gew.-Teilen n-Butylacrylat, 47 Gew.-Teilen Ethylacrylat, Angaben in Gew.-Teilen sind jeweils bezogen auf gesamten Feststoff, mittlerer Partikeldurchmesser (Gewichtsmittel) 172 nm, bestimmt durch Coulter Counter, T_{g}: - 19°C (Bindemittel b.1) dynamische Viskosität (23°C) 70 mPa·s,
20 g Verbindung der Formel 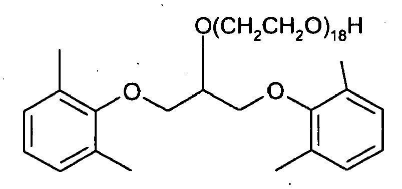
20 g einer 51 Gew.-% Lösung eines Umsetzungsprodukts von Hexamethyldiisocyanat mit n-C₁₈H₃₇(OCH₂CH₂)₁₅OH in Isopropanol/Wasser (Volumenanteile 2:3)

Man rührte über einen Zeitraum von 20 Minuten mit 5000 U/min (Ultra-Thurrax). Man erhielt eine Druckpaste mit einer dynamischen Viskosität von 30 dPa·s bei 23°C, gemessen mit einem Rotationsvikosimeter nach Haake.

### II. Bedrucken von Textil, Schritt (A), und thermische Behandlung, Schritt (B)

Man bedruckte mit Druckpaste aus I. ein Polyestervlies, Flächengewicht 90 g/cm² - mit einem Sieb, mesh 120 mit einem Streifenmuster.

Anschließend trocknete man in einem Trockenschrank über einen Zeitraum von 10 Minuten bei 100°C. Danach fixierte man in einem Trockenschrank bei einer Temperatur von 150°C über einen Zeitraum von 5 Minuten.
Man erhielt bedrucktes und thermisch behandeltes Polyestervlies.

### III. Abscheiden eines weiteren Metalls, Schritt (C)

### III.1 Abscheiden von Kupfer ohne externe Spannungsquelle

Bedrucktes und thermisch behandeltes Polyestervlies aus II. wurde über einen Zeitraum von 10 Minuten in einem Bad (Zimmertemperatur) behandelt, das wie folgt zusammengesetzt war:
1,47 kg CuSO₄·5 H₂O
382 g H₂SO₄
5,1 I destilliertes Wasser
1,1 g NaCl
5 g C₁₃/C₁₅-Alkyl-O-(EO)₁₀(PO)₅-CH₃
(EO: CH₂-CH₂-O, PO: CH₂-CH(CH₃)-O)

Man entnahm das Polyestervlies, spülte zweimal unter fließendem Wasser und trocknete bei 90°C über einen Zeitraum von einer Stunde.

Man erhielt erfindungsgemäßes metallisiertes Textil T-1.

### III.2 Abscheiden von weiterem Metall durch Galvanisieren

Bedrucktes und thermisch behandeltes Polyestervlies aus II. wurde jeweils in einem Galvanisierbad behandelt, das wie folgt zusammengesetzt war:
1,47 kg CuSO₄·5 H₂O
382 g H₂SO₄
5,1 I destilliertes Wasser
1,1 g NaCl
5 g C₁₃/C₁₅-Alkyl-O-(EO)₁₀(PO)₅-CH₃

Man entnahm das Polyestervlies, spülte zweimal unter fließendem Wasser und trocknete bei 90°C über einen Zeitraum von einer Stunde.

### III.2.1 Galvanisieren über einen Zeitraum von 10 Minuten

Man galvanisierte in einem vorstehend beschriebenen Galvanisierbad über einen Zeitraum von 10 Minuten, wobei man eine Elektrode als Kathode verwendete und an der Kontaktstelle des bedruckten Polyestervlieses die Anode schaltete.

Man erhielt erfindungsgemäßes metallisiertes Textil T-2.

### III.2.1 Galvanisieren über einen Zeitraum von 30 Minuten

Man galvanisierte in einem vorstehend beschriebenen Galvanisierbad über einen Zeitraum von 30 Minuten, wobei man eine Elektrode als Kathode verwendete und an der Kontaktstelle des bedruckten Polyestervlieses die Anode schaltete.

Man erhielt erfindungsgemäßes metallisiertes Textil T-3.

### IV. Test der Beheizbarkeit

### IV.1 Test der Beheizbarkeit von T-2

Man testete zunächst erfindungsgemäßes metallisiertes Textil T-2, indem man einen Strom von (wie viel) angelegte (oder Spannung). Strom, Spannung und Widerstand verhielten sich gemäß Tabelle 1.

**Tabelle 1: Test der Beheizbarkeit von T-2**

| Nr. | U [V] | I [A] | T [°C] | Nr. | U [V] | I [A] | T [°C] | Nr. | U [V] | I [A] | T [°C] |
|---|---|---|---|---|---|---|---|---|---|---|---|
| 1 | 1 | - | 23,7 | 2 | 1 | 0,05 | 24,0 | 3 | 1 | - | 24 |
| 1 | 3 | 0,05 | 23,8 | 2 | 3 | 0,1 | 24,3 | 3 | 3 | 0,05 | 24,3 |
| 1 | 5 | 0,1 | 24 | 2 | 5 | 0,2 | 24,7 | 3 | 5 | 0,15 | 24,6 |
| 1 | 7 | 0,2 | 24,4 | 2 | 7 | 0,3 | 25,3 | 3 | 7 | 0,2 | 25,1 |
| 1 | 10 | 0,3 | 25,5 | 2 | 10 | 0,4 | 26,8 | 3 | 10 | 0,3 | 26,1 |
| 1 | 12 | 0,4 | 27 | 2 | 12 | 0,5 | 28,5 | 3 | 12 | 0,35 | 27,2 |
| R an Kontaktstelle: 38 Ω | | | | R an Kontaktstelle: 24 Ω | | | | R an Kontaktstelle: 35 Ω | | | |

### IV.2 Test der Beheizbarkeit von T-3

Man testete zunächst erfindungsgemäßes metallisiertes Textil T-3, indem man einen Strom gemäß Tabelle 2 angelegte (oder Spannung). Strom, Spannung und Widerstand verhielten sich gemäß Tabelle 2.

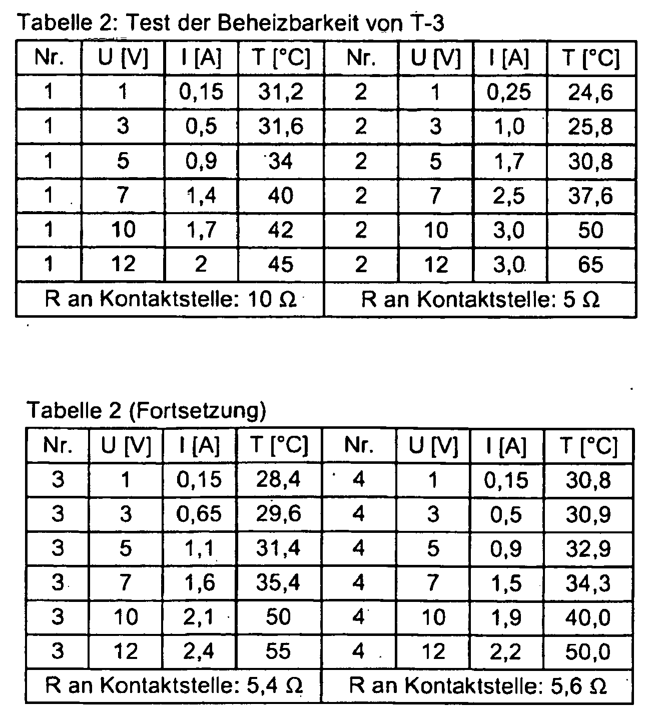

## Patentansprüche

1. Verfahren zur Herstellung eines metallisierten textilen Flächengebildes, **dadurch gekennzeichnet, dass** man ein textiles Flächengebilden
(A) mit einer wässrigen Druckformulierung bedruckt, enthaltend als Komponenten
(a) mindestens ein Metallpulver, gewählt aus pulverförmigem Zn, Ni, Cu, Sn, Co, Mn, Fe, Mg, Pb, Cr und Bi, Mischungen und Legierungen der vorstehend genannten Metalle,
(b) mindestens ein Bindemittel,
(c) mindestens einen Emulgator,
(d) gegebenenfalls mindestens einen Rheologiemodtfizierer,
(B) in einem oder mehreren Schritten thermisch behandelt,
(C) ein weiteres Metall auf dem textilen Flächengebilde abscheidet.

2. Verfahren nach Anspruch 1, **dadurch gekennzeichnet, dass** man textile Flächengebilde wählt aus Baumwolle und synthetischen Fasern und Mischungen von Baumwolle und synthetischen Fasern.

3. Verfahren nach Anspruch 1 oder 2, **dadurch gekennzeichnet, dass** man textile Flächengebilde wählt aus Gewebe und Vliesstoffen.

4. Verfahren nach einem der Ansprüche 1 bis 3, **dadurch gekennzeichnet, dass** man in Schritt (A) ein Muster von Metallpulver (a) aufdruckt, so dass das bedruckte, thermisch behandelte und mit einem weiteren Metall versehene metallisierte textile Flächengebilde partiell den elektrischen Strom leitet.

5. Verfahren nach einem der Ansprüche 1 bis 4, **dadurch gekennzeichnet, dass** es sich bei Metallpulver (a) um solches handelt, dass man durch thermische Zersetzung von Eisenpentacarbonyl gewonnen hat.

6. Verfahren nach einem der Ansprüche bis 5, **dadurch gekennzeichnet, dass** man in Schritt (C) ohne externe Spannungsquelle arbeitet und dass das weitere Metall in Schritt (C) in der elektrochemischen Spannungsreihe der Elemente ein stärker positives Normalpotenzial aufweist als Metall, das Metallpulver (a) zugrunde liegt.

7. Verfahren nach einem der Ansprüche 1 bis 5, **dadurch gekennzeichnet, dass** man in Schritt (C) mit externer Spannungsquelle arbeitet und dass das weitere Metall in Schritt (C) in der elektrochemischen Spannungsrelhe der Elemente ein stärker oder schwächer positives Normalpotenzial aufweist als Metall, das Metallpulver (a) zugrunde liegt.

8. Verfahren nach einem der Ansprüche 1 bis 7, **dadurch gekennzeichnet, dass** man in Schritt (A) ein Muster aufdruck.

9. Verfahren nach einem der Ansprüche 1 bis 8, **dadurch gekennzeichnet, dass** man Emulgator (c) wählt aus nichtionischen Emulgatoren.

10. Metallisierte textile Flächengebilde, erhältlich nach einem Verfahren nach einem der Ansprüche 1 bis 9.

11. Verwendung von metallisierten textilen Flächengebilden nach Anspruch 10 zur Herstellung von beheizbaren Textilien, von Textilien, die Strom in Wärme umwandeln, von Textilien, die elektrische Felder abschirmen können, von Textil-integrierter Elektronik und von RFID-Textilien.

12. Beheizbare Textilien, Textilien, die Strom in Wärme umwandeln, Textilien, die elektrische Felder abschirmen können, Textil-integrierte Elektronik und RFID Textilien, hergestellt unter Verwendung von metallisiertem textilem Flächengebilde nach Anspruch 10.

13. Beheizbare Textilien nach Anspruch 12, **dadurch gekennzeichnet, dass** es sich um beheizbare Autositze handelt.

## Claims

1. A process for producing a metalized textile fabric, which comprises a textile fabric being
(A) printed with an aqueous printing formulation comprising as components
(a) at least one metal powder selected from pulverulent Zn, Ni, Cu, Sn, Co, Mn, Fe, Mg, Pb, Cr and Bi, mixtures and alloys thereof,
(b) at least one binder,
(c) at least one emulsifier,
(d) optionally at least one rheology modifier,
(B) thermally treated in one or more steps,
(C) depositing a further metal on the textile fabric.

2. The process according to claim 1 wherein textile fabrics are selected from cotton and synthetic fibers and blends of cotton and synthetic fibers.

3. The process according to any one of claims 1 or 2 wherein textile fabrics are selected from wovens and nonwovens.

4. The process according to any one of claims 1 to 3 wherein a pattern of metal powder (a) is printed onto the textile fabric in step (A), so that the metalized textile fabric printed, thermally treated and provided with a further metal partially conducts electric current.

5. The process according to any one of claims 1 to 4 wherein metal powder (a) is obtained by thermal decomposition of iron pentacarbonyl.

6. The process according to any one of claims 1 to 5 wherein no external source of voltage is used in step (C) and the further metal in step (C) has a more strongly positive standard potential in the electrochemical series of the elements than the metal underlying metal powder (a).

7. The process according to any one of claims 1 to 5 wherein an external source of voltage is used in step (C) and the further metal in step (C) has a more strongly or more weakly positive standard potential in the electrochemical series of the elements than the metal underlying metal powder (a).

8. The process according to any one of claims 1 to 7 wherein a pattern is printed onto the textile fabric in step (A).

9. The process according to any one of claims 1 to 8 wherein emulsifier (c) is selected from nonionic emulsifiers.

10. A metalized textile fabric obtainable by a process according to any one of claims 1 to 9.

11. The use of a metalized textile fabric according to claim 10 for producing a heatable textile, a textile that converts electricity into heat, a textile able to screen off an electric field, a textile-integrated electronic system and an RFID textile.

12. A heatable textile, a textile that converts electricity into heat, a textile able to screen off an electric field, a textile-integrated electronic system and an RFID textile, obtained by use of a metalized textile fabric according to claim 10.

13. The heatable textile according to claim 12 comprising a heatable car seat.

## Revendications

1. Procédé de fabrication d'une structure plate textile métallisée, **caractérisé en ce qu'**une structure plate textile
(A) est imprimée avec une formulation d'impression aqueuse, contenant en tant que composants
(a) au moins une poudre métallique, choisie parmi le Zn, Ni, Cu, Sn, Co, Mn, Fe, Mg, Pb, Cr et Bi pulvérulent, les mélanges et les alliages des métaux susmentionnés,
(b) au moins un liant,
(c) au moins un émulsifiant,
(d) éventuellement au moins un modificateur de rhéologie,
(B) est traitée thermiquement en une ou plusieurs étapes,
(C) un métal supplémentaire est déposé sur la structure plate textile.

2. Procédé selon la revendication 1, **caractérisé en ce que** les structures plates textiles sont choisies parmi le coton et les fibres synthétiques et les mélanges de coton et de fibres synthétiques.

3. Procédé selon la revendication 1 ou 2, **caractérisé en ce que** les structures plates textiles sont choisies parmi les tissus tissés et non tissés.

4. Procédé selon l'une quelconque des revendications 1 à 3, **caractérisé en ce qu'**à l'étape (A), un motif de poudre métallique (a) est imprimé, de manière à ce que la structure plate textile métallisée imprimée, traitée thermiquement et munie d'un métal supplémentaire conduise partiellement le courant électrique.

5. Procédé selon l'une quelconque des revendications 1 à 4, **caractérisé en ce que** la poudre métallique (a) est obtenue par décomposition thermique de pentacarbonyle de fer.

6. Procédé selon l'une quelconque des revendications 1 à 5, **caractérisé en ce que** l'étape (C) est réalisée sans source de tension externe et **en ce que** le métal supplémentaire à l'étape (C) présente un potentiel normal plus fortement positif dans la série électrochimique des éléments que le métal qui est à la base de la poudre métallique (a).

7. Procédé selon l'une quelconque des revendications 1 à 5, **caractérisé en ce que** l'étape (C) est réalisée avec une source de tension externe et **en ce que** le métal supplémentaire à l'étape (C) présente un potentiel normal plus fortement ou plus faiblement positif dans la série électrochimique des éléments que le métal qui est à la base de la poudre métallique (a).

8. Procédé selon l'une quelconque des revendications 1 à 7, **caractérisé en ce qu'**un motif est imprimé à l'étape (A).

9. Procédé selon l'une quelconque des revendications 1 à 8, **caractérisé en ce que** l'émulsifiant (c) est choisi parmi les émulsifiants non ioniques.

10. Structures plates textiles métallisées, pouvant être obtenues par un procédé selon l'une quelconque des revendications 1 à 9.

11. Utilisation de structures plates textiles métallisées selon la revendication 10 pour la fabrication de textiles chauffants, de textiles qui transforment un courant en chaleur, de textiles qui peuvent faire écran à un champ électrique, de textiles intégrant des composants électronique et de textiles RFID.

12. Textiles chauffants, textiles qui transforment un courant en chaleur, textiles qui peuvent faire écran à un champ électrique, textiles intégrant des composants électronique et textiles RFID, fabriqués en utilisant une structure plate textile métallisée selon la revendication 10.

13. Textiles chauffants selon la revendication 12, **caractérisés en ce qu'**il s'agit de sièges automobiles chauffants.
